Europäisches Patentamt

(19) European Patent Office

Office européen des brevets

(11) Numéro de publication : **0 109 714**
**B1**

(12) # FASCICULE DE BREVET EUROPÉEN

(45) Date de publication du fascicule du brevet :
12.02.86

(51) Int. Cl.⁴ : **H 03 B   9/14, H 01 P   1/218**

(21) Numéro de dépôt : **83201627.3**

(22) Date de dépôt : **15.11.83**

(54) Circuit magnétique pour résonateur d'oscillateur à bille de grenat de fer et d'yttrium.

(30) Priorité : **22.11.82 FR 8219525**

(43) Date de publication de la demande :
**30.05.84 Bulletin 84/22**

(45) Mention de la délivrance du brevet :
**12.02.86 Bulletin 86/07**

(84) Etats contractants désignés :
**DE FR GB SE**

(56) Documents cités :
**FR-A- 1 208 990**
**GB-A- 1 360 080**
**US-A- 3 085 212**
**US-A- 3 576 503**
**IEEE TRANSACTIONS ON MICROWAVE THEORY
AND TECHNIQUES, vol. MTT-18, no. 4, avril 1970,
pages 205-212, IEEE, New York, USA R.L. FJERSTAD:
"Some design considerations and realizations of
irirs-coupled YIG-tuned filters in the 12-40 GHz
region"**
**MICROWAVE JOURNAL, vol. 18, no. 9, septembre
1975, pages 33-35,50, Horizon House, Dedham; USA
K.E. ZUBLIN et al.: "Ka-band YIG-tuned GAAs oscillator"**

(73) Titulaire : **R.T.C. LA RADIOTECHNIQUE-COMPELEC
Société anonyme dite:
51 rue Carnot
F-92150 Suresnes (Hauts-de-Seine) (FR)
FR
N.V. Philips' Gloeilampenfabrieken
Groenewoudseweg 1
NL-5621 BA Eindhoven (NL)
DE GB SE**

(72) Inventeur : **Doyen, Daniel
Société Civile S.P.I.D. 209, rue de l'Université
F-75007 Paris (FR)**

(74) Mandataire : **Charpail, François et al
Société Civile S.P.I.D. 209, rue de l'Université
F-75007 Paris (FR)**

Jouve, 18. rue St-Denis, 75001 Paris, France

### Description

La présente invention concerne un circuit magnétique pour résonateur d'oscillateur à bille de grenat de fer et d'yttrium, constitué par une première pièce polaire cylindrique comportant une bobine disposée autour d'un noyau axial, et une deuxième pièce polaire cylindrique à fond plat, les deux pièces polaires cylindriques étant réunies l'une à l'autre afin de fermer le circuit magnétique, et la bille de grenat de fer et d'yttrium étant placée dans un entrefer défini par une extrémité du noyau axial et la partie du fond plat en regard de ladite extrémité. Un tel circuit est connu par exemple par le document US-A-3 576 503.

L'invention trouve une application particulièrement avantageuse dans le domaine des oscillateurs hyperfréquence ayant comme résonateur une bille de grenat de fer et d'yttrium, connu également sous le nom de YIG.

Les circuits magnétiques du type de celui décrit dans le préambule offrent l'avantage d'un usinage facile dans la mesure où la deuxième pièce polaire présente un fond plat, ce qui permet par ailleurs de loger commodément le circuit hyperfréquence couplé avec la bille de YIG, en le fixant sur ledit fond plat. Cependant, ces circuits magnétiques connus ont l'inconvénient de présenter des fuites magnétiques assez importantes avec la conséquence qu'aux hautes fréquences, par exemple supérieures à 10 GHz, la relation fréquence-courant dans la bobine n'est plus linéaire puisque, à cause des fuites et de la saturation du matériau, il faut faire passer dans la bobine un courant plus important que nécessaire. C'est le but de l'invention de remédier à cet inconvénient tout en conservant l'essentiel des avantages du fond plat.

En effet, selon la présente invention, un circuit magnétique pour résonateur d'oscillateur à bille de grenat de fer et d'yttrium, constitué par une première pièce polaire cylindrique comportant une bobine disposée autour d'un noyau axial, et une deuxième pièce polaire cylindrique à fond plat, les deux pièces polaires cylindriques étant réunies l'une à l'autre afin de fermer le circuit magnétique, et la bille de grenat de fer et d'yttrium étant placée dans un entrefer défini par une extrémité du noyau axial et la partie du fond plat en regard de ladite extrémité, est notamment remarquable en ce qu'une gorge circulaire est aménagée dans le fond plat autour de ladite partie en regard de l'extrémité du noyau axial.

Ainsi, la gorge pratiquée dans le fond plat à la périphérie de l'entrefer permet de réduire de façon très sensible les fuites magnétiques du circuit, d'où une amélioration de la linéarité courant-fréquence à fort champ et une meilleure sensibilité du dispositif. On peut alors envisager d'utiliser une bobine de plus faible dimension ainsi qu'un circuit magnétique plus réduit entraînant un gain en volume et en poids. De plus, il faut signaler que la diminution de la quantité de matériau mise en jeu conduit à une réduction du traînage magnétique et, par conséquent, à une réduction du temps de commutation.

D'autre part, dans un mode de réalisation préférentiel de l'invention, il est prévu que la largeur de la gorge est comprise entre 1 et 2 fois la largeur de l'entrefer et que la profondeur de ladite gorge est de l'ordre de la largeur dudit entrefer. Ces caractéristiques dimensionnelles conduisent à une gorge de petite dimension qui permet de préserver les avantages d'un fond plat pour la deuxième pièce polaire, à savoir usinage facile et possibilité de loger le circuit hyperfréquence en le plaquant sur le fond plat avec l'avantage supplémentaire d'une bonne évacuation thermique.

La description qui va suivre en regard du dessin annexé, donné à titre d'exemple non limitatif, fera bien comprendre en quoi consiste l'invention et comment elle peut être réalisée.

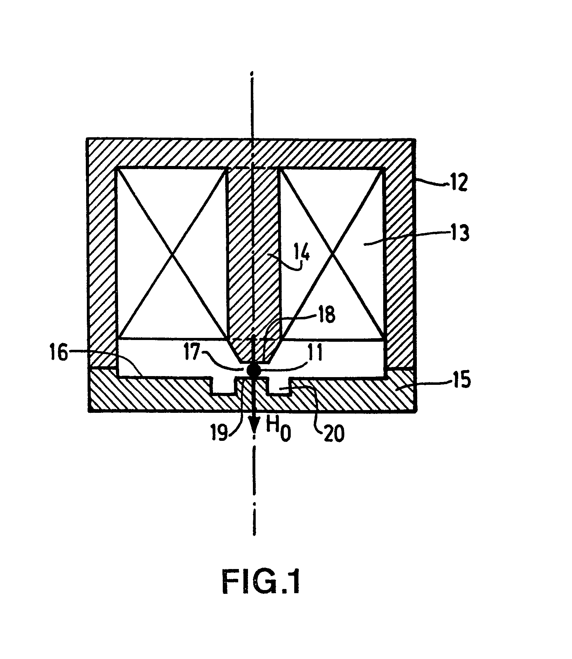

La figure 1 est une vue en coupe d'un résonateur d'oscillateur hyperfréquence selon l'invention.

Le circuit magnétique pour un résonateur d'oscillateur à bille 11 de grenat de fer et d'yttrium, montré à la figure 1, est constitué par une première pièce polaire cylindrique 12 comportant une bobine 13 disposée autour d'un noyau axial 14 et par une deuxième pièce polaire cylindrique 15 à fond plat 16. Les deux pièces polaires cylindriques 12, 15 sont réunies l'une à l'autre afin de fermer le circuit magnétique, et la bille 11 de YIG est placée dans un entrefer 17 défini par une extrémité 18 du noyau axial 14 et de la partie 19 du fond plat 16 en regard de ladite extrémité 18. Comme on peut le voir à la figure 1, une gorge 20 est aménagée dans le fond plat 16 autour de ladite partie 19 en regard de l'extrémité 18 du noyau axial 14. Cette disposition a pour but, conformément à l'invention, de réduire les fuites magnétiques à la périphérie de l'entrefer et donc d'augmenter la linéarité courant-fréquence de la source ainsi que d'améliorer sa sensibilité.

Dans un mode de réalisation avantageux de l'invention, la largeur de la gorge 20 est comprise entre 1 et 2 fois la largeur de l'entrefer 17 et la profondeur de ladite gorge est de l'ordre de la largeur dudit entrefer. Plus précisément, la Demanderesse a réalisé un circuit magnétique conforme à l'invention dans lequel l'entrefer avait une largeur de 1,8 mm et dont la gorge avait 2,75 mm de largeur et 1,5 mm de profondeur. Par ailleurs, la Demanderesse a également constaté une nette amélioration de la linéarité de la source hyperfréquence munie du circuit magnétique selon l'invention. En effet, elle a observé que la non-linéarité, calculée par la différence entre la fréquence effective et la fréquence attendue pour un dispositif parfaitement linéaire, était divisée par plus de 8 à 18 GHz en passant de 260 MHz à 30 MHz, de même que la zone de saturation était repoussée de plus de 1 GHz vers les hautes fréquences.

## Revendications

1. Circuit magnétique pour résonateur d'oscillateur à bille (11) de grenat de fer et d'yttrium, constitué par une première pièce polaire cylindrique (12) comportant une bobine (13) disposée autour d'un noyau axial (14) et une deuxième pièce polaire cylindrique (15) à fond plat (16), les deux pièces polaires cylindriques (12, 15) étant réunies l'une à l'autre afin de fermer le circuit magnétique, et la bille (11) de grenat de fer et d'yttrium étant placée dans un entrefer (17) défini par une extrémité (18) du noyau axial (14) et la partie (19) du fond plat en regard de ladite extrémité (18), caractérisé en ce qu'une gorge circulaire (20) est aménagée dans le fond plat (16) autour de ladite partie (19) en regard de l'extrémité (18) du noyau axial (14).

2. Circuit magnétique selon la revendication 1, caractérisé en ce que la largeur de la gorge (20) est comprise entre 1 et 2 fois la largeur de l'entrefer (17) et que la profondeur de ladite gorge est de l'ordre de la largeur dudit entrefer.

## Claims

1. A magnetic circuit for an yttrium-iron garnet crystal resonator (11) for an oscillator, formed by a first cylindrical pole piece (12) comprising a coil (13) provided around an axial core (14) and a second cylindrical pole piece (15) having a flat bottom (16), the two cylindrical pole pieces (12, 15) being joined together so as to close the magnetic circuit, and the yttrium-iron garnet crystal (11) being placed in a gap (17) defined by an end (18) of the axial core (14) and the part (19) of the flat bottom facing the said end (18), characterized in that a circular groove (20) is arranged in the flat bottom (16) around the said part (19) facing the end (18) of the axial core (14).

2. A magnetic circuit as claimed in Claim 1, characterized in that the width of the groove (20) is comprised between 1 and 2 times the width of the gap (17) and that the depth of the said groove is of the order of the width of the said gap.

## Patentansprüche

1. Magnetkreis für einen Yttrium-Eisengranat-Kristallresonator (11) für einen Oszillator, der durch ein erstes zylinderförmiges Polstück (12) mit einer Spule (13), die um einen axialen Kern (14) vorgesehen ist und durch ein zweites zylinderförmiges Polstück (15) mit einem flachen Boden (16) gebildet ist, wobei die zwei zylinderförmigen Polstücke (12, 15) zusammengefügt sind um den Magnetkreis zu schliessen und wobei das Yttrium-Eisengranat-Kristall (11) in einem Spalt (17) angeordnet ist, der durch ein Ende (18) des axialen Kerns (14) und denjenigen Teil (18) des flachen Bodens, der dem genannten Ende (18) zugewandt ist, definiert wird, dadurch gekennzeichnet, dass in dem flachen Boden (16) um den genannten Teil (19), der dem Ende (18) des axialen Kerns (14) zugewandt ist, eine kreisförmige Rille (20) vorgesehen ist.

2. Magnetkreis nach Anspruch 1, dadurch gekennzeichnet, dass die Breite der Rille (20) zwischen der Breite und der doppelten Breite des Spaltes (17) liegt und dass die Tiefe der genannten Rille in der Grössenordnung der Breite des genannten Spaltes liegt.

FIG.1